# EUROPEAN PATENT APPLICATION

(11) **EP 4 776 831 A1**
(43) Date of publication of application: **15.07.2026**
(21) Application number: 25216201.1
(22) Date of filing: 17.11.2025
(51) Int. Cl.: H10W 20/40, H10D 30/66, H10W 42/00

(54) **TRANSISTOR GATE RUNNER TOPOLOGY**

(30) Priority: 14.01.2025 US 202563745058 P; 10.10.2025 US 202519355346
(71) Applicant: Semiconductor Components Industries, LLC, Scottsdale, AZ 85250 (US)
(72) Inventor: MALOUSEK, Roman, 74401 Frenstat pod Radhostem (CZ)
(74) Representative: Manitz Finsterwald Patent- und Rechtsanwaltspartnerschaft mbB

(57) **Abstract**

A transistor is disclosed. The transistor includes a termination region extending around an exterior of a semiconductor die, a transition region located interior to the termination region, a first active region located interior to the transition region along at least a first edge of the semiconductor die, and a second active region above which a source pad area is included. The transistor further includes a gate runner including at least a first side portion located between the first active region and the second active region and extending parallel to the first edge of the semiconductor die.

## Description

This application claims the benefit of provisional patent application No. 63/745,058, filed January 14, 2025, which is hereby incorporated by reference herein in its entirety.

### TECHNICAL FIELD

The disclosure relates generally to metal-oxide semiconductor field-effect transistors (MOSFETs), and particularly to gate runner topologies for MOSFETs.

### BACKGROUND

MOSFETs may be used in power electronics, such as switching power converters and inverters. Such MOSFETs may be required to switch inductive loads at high switching frequencies. The on-state resistance and the switching speed of such MOSFETs may therefore be important design parameters when using MOSFETs in such high-power applications. In some applications, a MOSFET may be formed as a discrete component included in an integrated circuit package. To reduce the resistance in the current path of a power MOSFET, the integrated circuit package may include low-resistance bond, formed by a ribbon bonding or a sinter bonding process for example, to connect one or more source pads, for example, to the lead frame. The inventor of embodiments of the present disclosure has recognized that such bonding may cause excessive forces to the bonding area of the semiconductor die during the assembly process. The inventor of embodiments of the present disclosure has also recognized that such forces during the assembly process may destroy gate runner structures underlying the source pad, thereby resulting in the loss of the primary function of the MOSFET. Embodiments of the present disclosure may address one or more of these challenges.

### SUMMARY

The examples herein enable a gate runner topology to improve the reliability, on-state resistance, and switching speed, of transistors used in high-power applications.

According to one embodiment, a transistor includes a termination region extending around an exterior of a semiconductor die, a transition region located interior to the termination region, a first active region located interior to the transition region along at least a first edge of the semiconductor die, a second active region above which a source pad area is included, and a gate runner including at least a first side portion located between the first active region and the second active region and extending parallel to the first edge of the semiconductor die. In some embodiments, the first side portion extends parallel to the first edge of the semiconductor die along a full length of the first active region. In other embodiments, the first side portion extends parallel to the first edge of the semiconductor die along a partial length of the first active region. In the same or different embodiments, the first side portion of the gate runner is separated from the transition region by the first active region. In the same or different embodiments, the first active region has a first width that is less than a second width of the second active region by a factor of 10 or more. In the same or different embodiments, the transistor further includes a third active region located interior to the transition region along at least a second edge of the semiconductor die that opposes the first edge of the semiconductor die. In the same or different embodiments, the gate runner further includes a second side portion located between the third active region and the second active region and extending parallel to the second edge of the semiconductor die, and a cross-bar extending from the first side portion to the second side portion. In the same or different embodiments, the first side portion extends parallel to the first edge of the semiconductor die along a full length of the first active region, and the second side portion extends parallel to the second edge of the semiconductor die along a full length of the third active region. In the same or different embodiments, the first side portion extends parallel to the first edge of the semiconductor die along a partial length of the first active region, and the second side portion extends parallel to the second edge of the semiconductor die along a partial length of the third active region. In the same or different embodiments, the transistor is formed with a first metal layer and a second metal layer, the gate runner is formed on the first metal layer, and the gate runner is isolated from source metal on the first metal layer and the second metal layer by a dielectric. In the same or different embodiments, the transistor further comprises a p-type blocking region located under the gate runner. In the same or different embodiments, the transistor is a MOSFET. In the same or different embodiments, the transistor is a JFET. In the same or different embodiments, the semiconductor die is formed with a silicon carbide substrate.

According to another embodiment, a transistor includes a termination region extending around an exterior of a semiconductor die, a transition region located interior to the termination region, a first active region located interior to the transition region along at least a first edge of the semiconductor die, a second active region above which multiple source pad areas are included, a third active region located interior to the transition region along at least a second edge of the semiconductor die that opposes the first edge of the semiconductor die, and a gate runner including a first side portion located between the first active region and the second active region and extending parallel to the first edge of the semiconductor die, a second side portion located between the third active region and the second active region and extending parallel to the second edge of the semiconductor die, a cross-bar extending from the first side portion to the second side portion, and a central portion extending from the cross-bar and parallel to a length of the first side portion and the second side portion. In some embodiments, the central portion of the gate runner divides the second active region into a first subsection above which a first source pad area is located and a second subsection above which a second source pad area is located. In the same or different embodiments, the first side portion of the gate runner is separated from the transition region by the first active region. In the same or different embodiments, the first active region has a first width that is less than a second width of the second active region by a factor of 10 or more. In the same or different embodiments, the first side portion extends parallel to the first edge of the semiconductor die along a partial length of the first active region, and the second side portion extends parallel to the second edge of the semiconductor die along a partial length of the third active region. In the same or different embodiments, the transistor is formed with a first metal layer and a second metal layer, the gate runner is formed on the first metal layer, and the gate runner is isolated from source metal on the first metal layer and the second metal layer by a dielectric. In the same or different embodiments, the transistor further comprises a p-type blocking region located under the gate runner. In the same or different embodiments, the transistor is a MOSFET. In the same or different embodiments, the transistor is a JFET. In the same or different embodiments, the semiconductor die is formed with a silicon carbide substrate.

Another embodiment of the present disclosure includes a method for forming a transistor, wherein the method includes forming a termination region extending around an exterior of a semiconductor die, forming a transition region located interior to the termination region, forming a first active region located interior to the transition region along at least a first edge of the semiconductor die, forming a second active region above which a first source pad area is to be included, and forming a gate runner including at least a first side portion located between the first active region and the second active region and extending parallel to the first edge of the semiconductor die. In some embodiments, the method further includes disposing a p-type blocking region under a gate runner area where the gate runner is to be formed. In the same or different embodiments, the first side portion of the gate runner is separated from the transition region by the first active region. In the same or different embodiments, the first active region has a first width that is less than a second width of the second active region by a factor of 10 or more. In the same or different embodiments, the transistor is formed with a first metal layer and a second metal layer, the gate runner is formed on the first metal layer, and the gate runner is isolated from source metal on the first metal layer and the second metal layer by a dielectric. In the same or different embodiments, the transistor is a MOSFET. In the same or different embodiments, the transistor is a JFET. In the same or different embodiments, the semiconductor die is formed with a silicon carbide substrate.

### BRIEF DESCRIPTION OF THE DRAWINGS

A more complete understanding of the present embodiments may be acquired by referring to the following description taken in conjunction with the accompanying drawings, in which like reference numbers indicate like features.
FIG. 1 illustrates a top layout view of a transistor in accordance with embodiments of the present disclosure.
FIG. 2 illustrates a cross-section view of a transistor in accordance with embodiments of the present disclosure.
FIG. 3 illustrates a top layout view of a transistor in accordance with embodiments of the present disclosure.
FIG. 4 illustrates a top layout view of a transistor in accordance with embodiments of the present disclosure.
FIG. 5 illustrates a method for forming a transistor in accordance with embodiments of the present disclosure.

### DETAILED DESCRIPTION

Details of one or more embodiments are set forth in the description below and the accompanying drawings. Other features will be apparent from the description, drawings, and from the claims. The embodiments disclosed should not be interpreted, or otherwise used, as limiting the scope of the disclosure, including the claims. In addition, one skilled in the art understands that the following description has broad application, and the discussion of any embodiment is meant to be exemplary of that embodiment, and not intended to intimate that the scope of the disclosure, including the claims, is limited to that embodiment.

Various terms are used to refer to particular system components. Different companies may refer to a component by different names, and this disclosure does not intend to distinguish between components that differ in name but not form and function. In the following discussion and in the claims, the terms "including" and "comprising" are used in an open-ended fashion, and thus should be interpreted to mean "including, but not limited to." Also, the term "couple" or "coupled" is intended to encompass either an indirect connection or a direct connection. Thus, if a first device couples to, or is coupled to, a second device, that connection between the first device and the second device may be through a direct connection or through an indirect connection via other devices and connections.

Further, although the terms "first," "second," and so forth may be used herein to describe various elements, these elements should not be limited by these terms. Terms such as "first" and "second" may be used merely to distinguish one element from another. For example, a first element could be termed a second element, and, similarly, a second element could be termed a first element, without departing from the scope of the present disclosure. Further, the identification of a "first" element, does not necessarily require the presence of a "second" element. As used herein, the term "and/or" includes any and all combinations of one or more of the associated listed items.

The embodiments disclosed herein involve gate runner topologies for MOSFETs. The figures and corresponding disclosures describe in detail various gate runner examples, and how the example gate runners may be laid out relative to the termination region, the transition region, and the various active areas that may include one or more transistor cells. While the present disclosure may broadly refer to one or more active areas of the transistor, a person of ordinary skill in the art would appreciate that the active area may include the respective source region, channel region, drain region, gate structure, and/or drift region of the MOSFET cells included therein. The various MOSFET cells may be implemented as either planar channel, vertical channel, and/or trench MOSFET cells. Further, although embodiments herein describe various gate runner topologies for a MOSFET transistor, the gate runner topologies described herein may also be applied to other transistor types, such as junction field-effect transistors (JFETs). Further, the transistors described herein may be implemented on any suitable semiconductor substrate, including but not limited to silicon, silicon carbide, or gallium nitride, among others.

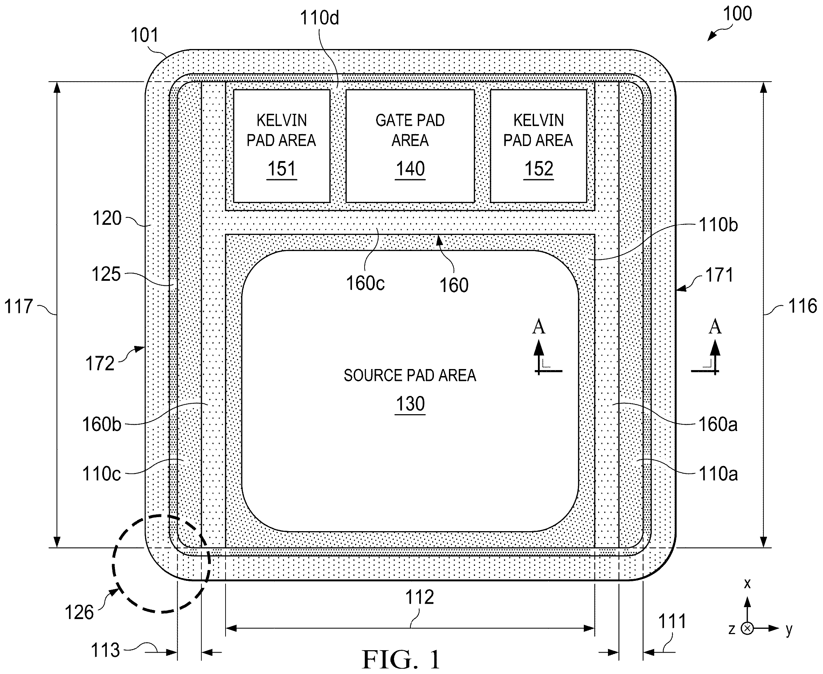

FIG. 1 illustrates a top layout view of transistor 100 in accordance with embodiments of the present disclosure. As shown in FIG. 1, transistor 100 may include source pad area 130, gate pad area 140, kelvin pad areas 151 and 152, and gate runner 160. Source pad area 130 may define a surface area of a patterned top metal layer (for example, a second metal layer) of semiconductor die 101 to which a bond wire or a bond ribbon, for example, may be bonded to thereby couple the source terminal of transistor 100 to the lead frame of an integrated circuit package. Gate pad area 140 may define a surface area of the patterned top metal layer of semiconductor die 101 to which a bond wire or a bond ribbon, for example, may be bonded to thereby couple the gate terminal of transistor 100 to the lead frame of the integrated circuit package. Further, kelvin pad areas 151 and 152 may define a surface area of the patterned top metal layer of semiconductor die 101 to which a bond wire or a bond ribbon, for example, may be bonded to couple the source terminal of transistor 100 to the lead frame of the integrated circuit package, thereby allowing for a sensing path to the source terminal of transistor 100 separate from the high current conduction path for the source terminal.

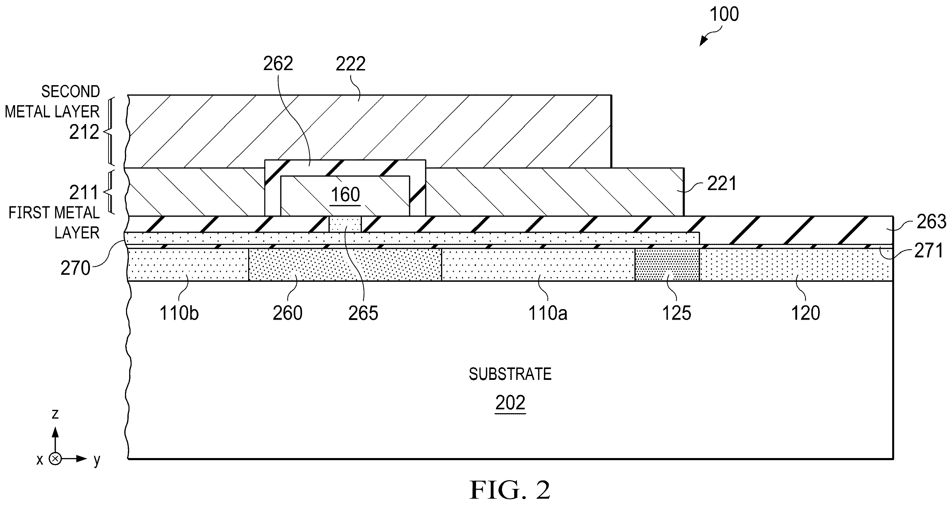

As described in further detail below with reference to FIG. 2, gate runner 160 may be formed on a first metal layer, which may be located under a second metal layer on which source pad area 130 may be defined. The first metal layer, and gate runner 160 in particular, may be formed with a metal or a metal alloy, such as aluminum, copper, or an alloy thereof. Gate runner 160 may be used, for example, to couple a gate pad (located in gate pad area 140) to the respective gate structures of the various transistor cells that may form transistor 100. Due to its high conductivity and low resistance, gate runner 160 may evenly distribute the gate signal from the gate pad to the respective gate structures (implemented, for example, in polysilicon) of the various transistor cells that may collectively form the active portion of transistor 100. As shown in FIG. 1, and as described in further detail below, various portions of gate runner 160 may be located outside of the source pad area 130 to which a source pad may be coupled. Accordingly, gate runner 160 may avoid physical stresses that may be incurred by the semiconductor die 101 during the bonding process when bond wires or bond ribbons, for example, are coupled to source pad area 130.

As shown in FIG. 1, transistor 100 may also include termination region 120, transition region 125, and various active regions, such as first active region 110a, second active region 110b, third active region 110c, and fourth active region 110d.

Termination region 120 may be formed around an exterior of semiconductor die 101. Termination region 120 may thus surround a plurality of transistor cells that collectively form the active portion of transistor 100. In some embodiments, termination region 120 may include one or more doped regions, formed for example by diffusion or implantation, and/or one or more trench structures, to reduce gradients of the electric field at geometrical sharp points associated with operation of transistor 100 at high voltages. Thus, termination region 120 may help maintain the breakdown voltage (BV) of the transistor cells close to a maximum BV as limited by material properties. For example, termination region 120 may prevent breakdown from occurring below a blocking entitlement of the plurality of transistor cells, for example, by terminating or gradually reducing high electric fields at the device periphery during off-state operation of transistor 100. In some embodiments, termination region 120 or portions of such may have an opposite conductivity type of the source and drain regions of the transistor cells. For example, in embodiments where transistor 100 is an NMOS transistor (n-type MOSFET), and the source regions and the drain regions of the transistor cells are n-type regions, termination region 120 may be a p-type region. And in embodiments where transistor 100 is an PMOS transistor (p-type MOSFET), and the source regions and the drain regions of the transistor cells are p-type regions, termination region 120 may be an n-type region.

Transition region 125 may be located interior to termination region 120. In some embodiments, transition region 125 may include a doping having the oppositive conductivity type of the source and drain regions of the transistor. For example, in embodiments where transistor is a NMOS (n-type MOSFET) with n-type source and drain regions, transition region 125 may be a p-type region, formed for example by diffusion or implantation, to reduce gradients of the electric field associated with operation of transistor 100 at high voltages.

As shown in FIG. 1, first active region 110a may be located interior to transition region 125 along at least a first edge 171 of semiconductor die 101. Second active region 110b may be located further to the interior of semiconductor die 101 relative to first active region 110a. Source pad area 130 may be located above (in the direction of the z-axis illustrated in FIG. 1) second active region 110b. Further, third active region 110c may be located interior to transition region 125 along at least a second edge 172 of semiconductor die 101 that opposes the first edge 171 of semiconductor die 101. In some embodiments, first active region 110a may have a first width 111 that is less than a second width 112 of second active region 110b. For example, first active region 110a may have a first width 111 that is less than a second width 112 of second active region 110b by a factor of 10 or more. In some embodiments, third active region 110c may have a third width 113 that is less than a second width 112 of second active region 110b. For example, third active region 110c may have a third width 113 that is less than a second width 112 of second active region 110b by a factor of 10 or more. In some embodiments, the third width 113 of third active region 110c may have the same value as the first width 111 of first active region 110a.

As also shown in FIG. 1, gate runner 160 may separate various active regions, including first active region 110a, second active region 110b, third active region 110c, and fourth active region 110d. For example, gate runner 160 may include at least a first side portion 160a located between first active region 110a and second active region 110b and extending parallel to the first edge 171 of semiconductor die 101. Accordingly, the first side portion 160a of gate runner 160 may be separated from transition region 125 by first active region 110a. In some embodiments such as shown in FIG. 1, the first side portion 160a of gate runner 160 may extend parallel to the first edge 171 of the semiconductor die 101 along a full length 116 of first active region 110a. In addition, gate runner 160 may include a second side portion 160b located between third active region 110c and second active region 110b and extending parallel to the second edge 172 of the semiconductor die 101. In some embodiments such as shown in FIG. 1, the second side portion 160b of gate runner 160 may extend parallel to the second edge 172 of the semiconductor die 101 along a full length 117 of third active region 110c. Further, gate runner 160 may further include cross-bar 160c extending from the first side portion 160a to the second side portion 160b. In some embodiments, cross-bar 160c may be coupled to the gate pad in gate pad area 140 via routing along a lower layer of metal routing (for example, in a first metal layer of semiconductor die), thereby coupling the entirety of gate runner 160 to the gate pad in gate pad area 140.

Semiconductor die 101 may include rounded corners, such as illustrated in corner area 126 of FIG. 1. Accordingly, termination region 120, transition region 125 may also include rounded corners. Further, first active region 110a and third active region 110c may also include rounded corners corresponding to the rounded corners of termination region 120 and transition region 125. The rounded corners of termination region 120, transition region 125, as well as first active region 110a and third active region 110c, may help reduce electric field peaks that may otherwise form at sharp corners and damage transistor 100 during operation at high voltages. In some embodiments, and as shown in FIG. 1, gate runner 160 may be configured to not intersect (from the top view perspective shown in FIG. 1) with the rounded corners of first active region 110a and third active region 110c. In other embodiments, however, gate runner 160 (and specifically first side portion 160a and second side portion 160b) may intersect with rounded corners of first active region 110a and third active region 110c, and may have ends or corners that are rounded at least in part to correspond to the rounded corner of transition region 125.

FIG. 2 illustrates a cross-section view of transistor 100 in accordance with embodiments of the present disclosure. Specifically, FIG. 2 illustrates a cross-section view of transistor 100 along cut-line AA shown in FIG. 1.

Transistor 100 may be formed on substrate 202. Substrate 202 may include any suitable semiconductor material for forming power transistors, including but not limited to silicon (Si), silicon carbide (SiC), or gallium nitride (GaN). As shown in FIG. 2, first active region 110a and second active region 110b may be disposed in different areas of substrate 202. As described above, although the various different doping and/or structures (for example, trench gate structures) internal to the active regions are omitted from the figure for the sake of simplicity, it is appreciated that these active areas may include the various elements of MOSFET cells (for example, the source region, the channel region, and the drain region of the MOSFET cells included therein) to form the transistor.

Transistor 100 may be formed with multiple metal layers. For example, transistor 100 may be formed with first metal layer 211 and second metal layer 212. As shown in FIG. 2, the various metal layers may be patterned to route different signals. For example, above first active region 110a and second active region 110b, first metal layer 211 and second metal layer 212 may be patterned to respectively include first-layer source metal 221 and second-layer source metal 222, which may be coupled together. Gate runner 160 may also be routed within a pattern of first metal layer 211. As shown in FIG. 2, gate runner 160 may be electrically isolated from first-layer source metal 221 and second-layer source metal 222 by dielectric 262 and dielectric 263. Dielectric 262 and dielectric 263 may be formed by any dielectric material, such as silicon dioxide, suitable to electrically isolate gate runner 160 from first-layer source metal 221 and second-layer source metal 222. As also shown in FIG. 2, transistor 100 may include a contact 265 that may couple gate runner 160 (formed on first metal layer 211) down to polysilicon 270. In some embodiments, polysilicon 270 (along with gate dielectric 271) may form the gate structure for one or more transistors cells otherwise formed in the active regions such as first active region 110a and second active region 110b. And in some embodiments, polysilicon 270 may also be used as a conductive material to route the gate signal from gate runner 160 to further gate structures (for example, to further polysilicon in trench gate structures) for the transistor cells in the active regions such as first active region 110a and second active region 110b.

As shown in FIG. 2, transistor 100 may include a blocking region 260 located under (in the direction of the z-axis) gate runner 160. In some embodiments, blocking region 260 may be a p-type blocking region located under gate runner 160. For example, in embodiments where transistor 100 is an NMOS transistor and substrate 202 is an n-type substrate, blocking region 260 may be implemented as a p-type blocking region, which may thus block gate runner 160 from electric fields in the underlying areas of substrate 202 during operation of transistor 100 under high-voltage conditions.

As also shown in FIG. 2, transition region 125 may be located adjacent to first active region 110a, which in turn may be located adjacent to (in the direction of the y-axis) the area of gate runner 160 and blocking region 260. Accordingly, gate runner 160 may be separated from transition region 125 (in the direction of the y-axis) by first active region 110a. In some embodiments, transition region 125 may include a p-type doping similar to that of blocking region 260. Further, as shown in FIG. 2, termination region 120 may extend from transition region 125 to the exterior of the semiconductor die 101. As described above with reference to FIG. 1, termination region 120 may include one or more doped regions, formed for example by diffusion or implantation, and/or one or more trench structures, to reduce gradients of the electric field at geometrical sharp points associated with operation of transistor 100 at high voltages.

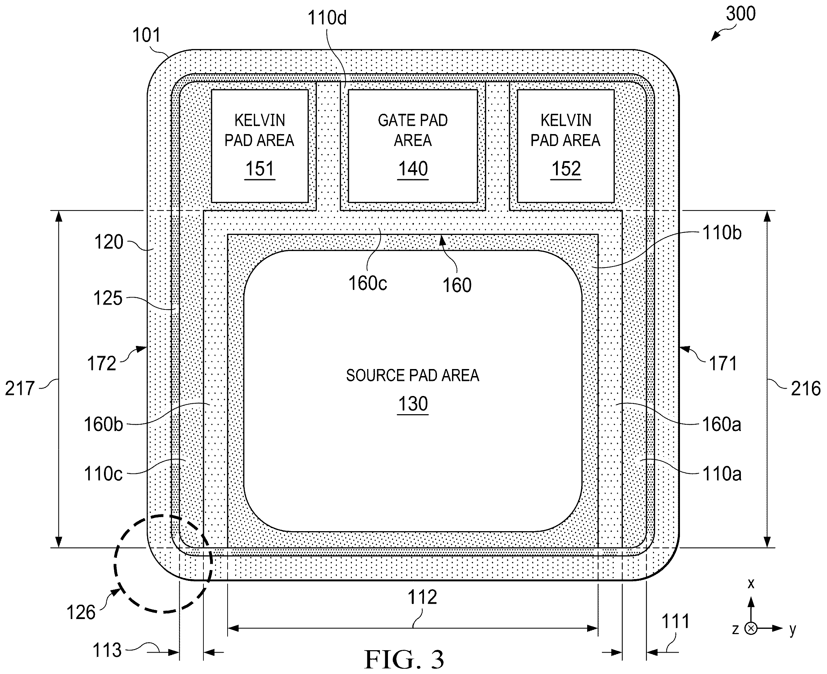

FIG. 3 illustrates a top layout view of transistor 300 in accordance with embodiments of the present disclosure. As shown in FIG. 3, transistor 300 may include similar elements as transistor 100, such as first active region 110a, second active region 110b, third active region 110c, termination region 120, transition region 125, and gate runner 160, which may be configured in, and may operate in, a similar manner as described above with reference to FIG. 1 and FIG. 2. As shown in FIG. 3, the first side portion 160a of gate runner 160 may extend parallel to the first edge 171 of semiconductor die 101 along a partial length 216 (as opposed to the full length 116 in FIG. 1 for example) of first active region 110a. Further, the second side portion 160b of gate runner 160 may extend parallel to the second edge 172 of semiconductor die 101 along a partial length 217 (as opposed to the full length 117 in FIG. 1 for example) of third active region 110c.

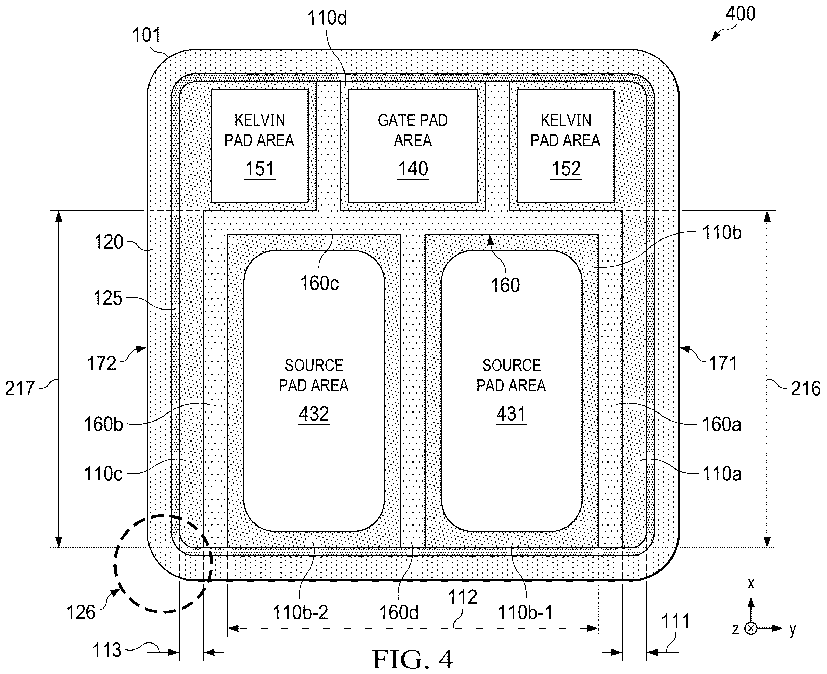

FIG. 4 illustrates a top layout view of transistor 400 in accordance with embodiments of the present disclosure. As shown in FIG. 4, transistor 400 may include similar elements as transistor 100, such as first active region 110a, second active region 110b, third active region 110c, termination region 120, transition region 125, and gate runner 160, which may be configured in, and may operate in, a similar manner as described above with reference to FIG. 1 and FIG. 2. As shown in FIG. 4, the first side portion 160a of gate runner 160 may extend parallel to the first edge 171 of semiconductor die 101 along a partial length 216 (as opposed to the full length 116 in FIG. 1 for example) of first active region 110a. Further, the second side portion 160b of gate runner 160 may extend parallel to the second edge 172 of semiconductor die 101 along a partial length 217 (as opposed to the full length 117 in FIG. 1 for example) of third active region 110c.

In addition, gate runner 160 may include a cross-bar 160c extending from the first side portion 160a to the second side portion 160b, and a central portion 160d extending from the cross-bar 160c and parallel to the length of the first side portion 160a and the second side portion 160b. As shown in FIG. 4, the central portion 160d of gate runner 160 may divide the second active region 110b into a first subsection 110b-1 above which a first source pad area 431 may be located and a second subsection 110b-2 above which a second source pad area 432 may be located. The inclusion of an additional central portion 160d of gate runner 160 may further help gate runner 160 evenly distribute the gate signal from the gate pad to the respective gate structures of the various transistor cells in the active areas of transistor 400.

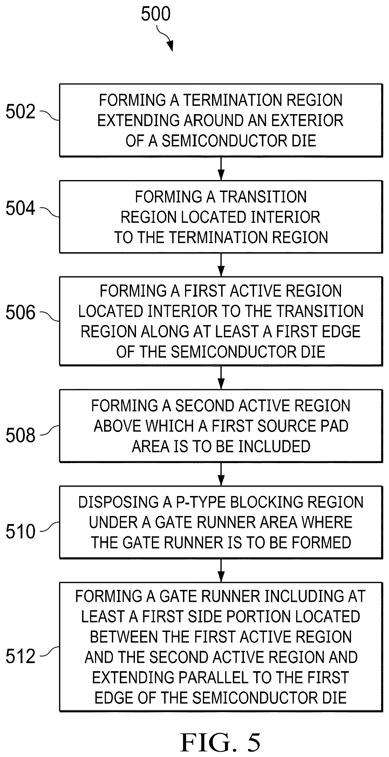

FIG. 5 illustrates a method 500 for forming a transistor in accordance with embodiments of the present disclosure.

Step 502 may include forming a termination region extending around an exterior of a semiconductor die. For example, as described above with reference to FIG. 1 and FIG. 2, termination region 120 may be formed extending around an exterior of semiconductor die 101. In some embodiments, termination region 120 may include one or more doped regions, formed for example by diffusion or implantation, and/or one or more trench structures, to reduce gradients of the electric field at geometrical sharp points associated with operation of transistor 100 at high voltages.

Step 504 may include forming a transition region located interior to the termination region. For example, as described above with reference to FIG. 1 and FIG. 2, transition region 125 may be formed in an area located interior to termination region 120. In some embodiments, transition region 125 may be formed by a p-type doping.

Step 506 may include forming a first active region located interior to the transition region along at least a first edge of the semiconductor die. For example, as described above with reference to FIG. 1 and FIG. 2, first active region 110a may be formed in an area located interior to transition region 125 along at least a first edge 171 of semiconductor die 101.

Step 508 may include forming a second active region above which a first source pad area is to be included. For example, as described above with reference to FIG. 1 and FIG. 2, second active region 110b may be formed in area further interior relative to first active region 110a and a first side portion 160a of gate runner 160. In some embodiments, source pad area 130 may be located above (in the direction of the z-axis) second active region 110b.

Step 510 may include disposing a p-type blocking region under a gate runner area where the gate runner is to be formed. For example, as described above with reference to FIG. 2, transistor 100 may include a blocking region 260 that may be implemented with p-type doping.

Step 512 may include forming a gate runner including at least a first side portion located between the first active region and the second active region and extending parallel to the first edge of the semiconductor die.

In some embodiments, the steps of method 500 may be performed with fewer or more steps than shown in FIG. 5. For the sake of simplicity, additional fabrication steps such as the formation of the source, gate, and drain regions, as well as the back-side metallization to form drain contacts, are omitted from the steps of method 500. Moreover, in some embodiments, certain steps of method 500 may be omitted, repeated, performed in parallel, performed in a different order than shown in FIG. 5, or performed recursively. Moreover, one or more steps of method 500, although shown in an order, may be performed at the same time or in a re-ordered manner. As one example, the formation of the termination region, the transition region, the first and second active regions, as well as the p-type block region, may be performed in whole or in part at the same time as each other by various doping and semiconductor process steps.

Although examples have been described above, other modifications and variations may be made from this disclosure without departing from the spirit and scope of the examples that are described herein. The above descriptions of various embodiments illustrate the principles of the invention. Numerous variations and modifications will become apparent to those skilled in the art based on the above disclosure. The following claims are intended to embrace all such variations and modifications.

## Claims

1. A transistor comprising:
a termination region extending around an exterior of a semiconductor die;
a transition region located interior to the termination region;
a first active region located interior to the transition region along at least a first edge of the semiconductor die;
a second active region above which a source pad area is included; and
a gate runner including at least a first side portion located between the first active region and the second active region and extending parallel to the first edge of the semiconductor die.

2. The transistor of claim 1, wherein the first side portion of the gate runner is separated from the transition region by the first active region.

3. The transistor of claim 1, wherein the first active region has a first width that is less than a second width of the second active region by a factor of 10 or more.

4. The transistor of claim 1, wherein the first side portion extends parallel to the first edge of the semiconductor die along a full length of the first active region.

5. The transistor of claim 1, wherein the first side portion extends parallel to the first edge of the semiconductor die along a partial length of the first active region.

6. The transistor of claim 1, further comprising:
a third active region located interior to the transition region along at least a second edge of the semiconductor die that opposes the first edge of the semiconductor die; and
wherein the gate runner further includes:
a second side portion located between the third active region and the second active region and extending parallel to the second edge of the semiconductor die; and
a cross-bar extending from the first side portion to the second side portion.

7. The transistor of claim 6, wherein:
the first side portion extends parallel to the first edge of the semiconductor die along a full length of the first active region; and
the second side portion extends parallel to the second edge of the semiconductor die along a full length of the third active region.

8. The transistor of claim 6, wherein:
the first side portion extends parallel to the first edge of the semiconductor die along a partial length of the first active region; and
the second side portion extends parallel to the second edge of the semiconductor die along a partial length of the third active region.

9. The transistor of claim 1, wherein:
the transistor is formed with a first metal layer and a second metal layer;
the gate runner is formed on the first metal layer; and
the gate runner is isolated from source metal on the first metal layer and the second metal layer by a dielectric.

10. The transistor of claim 1, further comprising a p-type blocking region located under the gate runner.

11. The transistor of claim 1, wherein the transistor is a MOSFET.

12. The transistor of claim 1, wherein the transistor is a JFET.

13. The transistor of claim 1, wherein the semiconductor die is formed with a silicon carbide substrate.

14. A transistor comprising:
a termination region extending around an exterior of a semiconductor die;
a transition region located interior to the termination region;
a first active region located interior to the transition region along at least a first edge of the semiconductor die;
a second active region above which multiple source pad areas are included;
a third active region located interior to the transition region along at least a second edge of the semiconductor die that opposes the first edge of the semiconductor die; and
a gate runner including:
a first side portion located between the first active region and the second active region and extending parallel to the first edge of the semiconductor die;
a second side portion located between the third active region and the second active region and extending parallel to the second edge of the semiconductor die;
a cross-bar extending from the first side portion to the second side portion; and
a central portion extending from the cross-bar and parallel to a length of the first side portion and the second side portion.

15. The transistor of claim 14, wherein the central portion of the gate runner divides the second active region into a first subsection above which a first source pad area is located and a second subsection above which a second source pad area is located.
